(19)

Europäisches Patentamt
European Patent Office
Office européen des brevets

(11) **EP 2 517 828 A1**

(12) **EUROPEAN PATENT APPLICATION**
published in accordance with Art. 153(4) EPC

(43) Date of publication:
**31.10.2012 Bulletin 2012/44**

(51) Int Cl.:
***B24B 37/00*** *(2012.01)* ***C08G 18/74*** *(2006.01)*
***H01L 21/304*** *(2006.01)*

(21) Application number: **10839232.5**

(22) Date of filing: **14.12.2010**

(86) International application number:
**PCT/JP2010/072430**

(87) International publication number:
**WO 2011/077999 (30.06.2011 Gazette 2011/26)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.12.2009 JP 2009290213**
**24.12.2009 JP 2009291613**
**28.07.2010 JP 2010169318**
**28.07.2010 JP 2010169319**

(71) Applicant: **JSR Corporation**
**Minato-ku**
**Tokyo 105-8640 (JP)**

(72) Inventors:
• **YOKOI, Katsutaka**
**Tokyo 105-8640 (JP)**

• **MAEKAWA, Ayako**
**Tokyo 105-8640 (JP)**
• **SHIDA, Hirotaka**
**Tokyo 105-8640 (JP)**
• **KAMO, Satoshi**
**Tokyo 105-8640 (JP)**
• **TONSHO, Shinji**
**Tokyo 105-8640 (JP)**
• **SATOU, Keiichi**
**Tokyo 105-8640 (JP)**
• **NISHIGUCHI, Naoki**
**Tokyo 105-8640 (JP)**
• **TANO, Hiroyuki**
**Tokyo 105-8640 (JP)**

(74) Representative: **TBK**
**Bavariaring 4-6**
**80336 München (DE)**

(54) **PAD FOR CHEMICAL MECHANICAL POLISHING AND METHOD OF CHEMICAL MECHANICAL POLISHING USING SAME**

(57)    A chemical mechanical polishing pad includes a polishing layer formed using a composition that includes a thermoplastic polyurethane, the polishing layer having a specific gravity of 1.15 to 1.30, and a durometer D hardness of 50 to 80.

FIG. 2

EP 2 517 828 A1

**Description**

TECHNICAL FIELD

The present invention relates to a chemical mechanical polishing pad, and a chemical mechanical polishing method using the chemical mechanical polishing pad.

BACKGROUND ART

A porous nonwoven fabric obtained by impregnating nonwoven fabric with a polyurethane solution, or a polyurethane molded product has been used as a polishing pad for polishing glass or a semiconductor material. The following polyurethane polishing pads have been studied as a chemical mechanical polishing pad suitable for chemical mechanical polishing (hereinafter may be referred to as "CMP") that planarizes the surface of a semiconductor substrate.

JP-T-8-500622 discloses a polishing pad wherein a filler-like component is dispersed in a polyurethane, JP-A-2000-17252 or Japanese Patent No. 3956364 discloses a polishing pad formed using a polyurethane foam, JP-A-2007-284625 discloses a polishing pad wherein the degree of crosslinking of a urethane resin is controlled by adjusting the amount of a polyol or an isocyanate so as to control the property values, and JP-A-2003-332277 discloses a polishing pad wherein the properties of the uppermost surface of the polishing layer are controlled, for example.

SUMMARY OF THE INVENTION

TECHNICAL PROBLEM

These chemical mechanical polishing pads formed using a known material are designed to improve the planarity of the polishing target surface during CMP by increasing the modulus of elasticity of the polishing layer, and the relationship between the specific gravity and the hardness of the polishing layer has not been sufficiently studied.

For example, the polishing pad disclosed in Japanese Patent No. 3956364 includes a polishing layer having a porous structure in order to increase the modulus of elasticity of the polishing layer. Although the polishing layer is formed using a material having high hardness, the specific gravity of the polishing layer decreases due to the porous structure, and the polishing layer is easily deformed to follow elevations and depressions of the polishing target surface due to the cushion effect of the porous structure. Therefore, the polishing target surface may be insufficiently planarized during CMP.

When suppressing deformation of the polishing layer along elevations and depressions of the polishing target surface by merely increasing the specific gravity of the polishing layer, the hardness of the polishing layer increases, so that the number of polishing defects (scratches) may increase due to polishing waste or pad waste that has entered the space between the polishing target surface and the polishing layer.

Several aspects of the invention may solve the above problems, and may provide a chemical mechanical polishing pad that can improve the planarity of the polishing target surface while suppressing occurrence of polishing defects (scratches) during CMP, and a chemical mechanical polishing method that utilizes the chemical mechanical polishing pad.

SOLUTION TO PROBLEM

The invention was conceived in order to solve at least some of the above problems, and may be implemented by the following aspects or application examples.

[Application Example 1]

According to one aspect of the invention, there is provided a chemical mechanical polishing pad including a polishing layer formed using a composition that includes a thermoplastic polyurethane, the polishing layer having a specific gravity of 1.15 to 1.30 and a durometer D hardness of 50 to 80.

[Application Example 2]

In the chemical mechanical polishing pad according to Application Example 1, the polishing layer may have a residual strain of 2 to 10% when applying tension to the polishing layer.

[Application Example 3]

In the chemical mechanical polishing pad according to Application Example 1 or 2, the polishing layer may have a volume change rate of 0.8 to 5.0% when immersed in water at 23°C for 24 hours.

[Application Example 4]

In the chemical mechanical polishing pad according to any one of Application Examples 1 to 3, the polishing layer may have a surface hardness of 2 to 10 N/mm$^2$ after being immersed in water at 23°C for 4 hours.

[Application Example 5]

In the chemical mechanical polishing pad according to any one of Application Examples 1 to 4, the thermoplastic polyurethane may include a repeating unit derived from at least one compound selected from an alicyclic isocyanate and an aromatic isocyanate.

[Application Example 6]

In the chemical mechanical polishing pad according to any one of Application Examples 1 to 5, the composition may further include water-soluble particles.

[Application Example 7]

According to another aspect of the invention, there is provided a chemical mechanical polishing method including chemically and mechanically polishing a polishing target using the chemical mechanical polishing pad according to any one of Application Examples 1 to 6.

EFFECTS OF THE INVENTION

The chemical mechanical polishing pad according to one aspect of the invention can improve the planarity of the polishing target surface while suppressing occurrence of polishing defects (scratches) during CMP since the chemical mechanical polishing pad includes the polishing layer that is formed using the composition that includes the thermoplastic polyurethane, and has a specific gravity and a hardness within the specific range.

BRIEF DESCRIPTION OF DRAWINGS

FIG. 1A is a schematic view illustrating the concept of the durometer D hardness of a polishing layer.
FIG. 1B is a schematic view illustrating the concept of the durometer D hardness of a polishing layer.
FIG. 2 is a schematic view illustrating the concept of the residual strain of a polishing layer when applying tension.
FIG. 3A is an enlarged view of an area I in FIG. 2 that illustrates the concept of the residual strain of a polishing layer when applying tension.
FIG. 3B is an enlarged view of an area I in FIG. 2 that illustrates the concept of the residual strain of a polishing layer when applying tension.
FIG. 3C is an enlarged view of an area I in FIG. 2 that illustrates the concept of the residual strain of a polishing layer when applying tension.
FIG. 3D is an enlarged view of an area I in FIG. 2 that illustrates the concept of the residual strain of a polishing layer when applying tension.
FIG. 3E is an enlarged view of an area I in FIG. 2 that illustrates the concept of the residual strain of a polishing layer when applying tension.
FIG. 4A is a schematic view illustrating the concept of the volume change rate of a polishing layer.
FIG. 4B is a schematic view illustrating the concept of the volume change rate of a polishing layer.
FIG. 5A is a schematic view illustrating the concept of the surface hardness of a polishing layer.
FIG. 5B is a schematic view illustrating the concept of the surface hardness of a polishing layer.

DESCRIPTION OF EMBODIMENTS

Preferred embodiments of the invention are described in detail below. Note that the term "wet state" used herein refers to the state of a polishing layer that has been immersed in water at 23°C for 4 hours or more. The term "hardness" used herein refers to durometer D hardness, and the term "surface hardness" used herein refers to universal hardness (HU: N/mm$^2$). Note that the surface hardness of a polishing layer in the wet state is indicated by universal hardness (HU: N/mm$^2$) measured when applying a constant pressure to the polishing layer (see the examples).

1. Chemical mechanical polishing pad

A chemical mechanical polishing pad according to one embodiment of the invention includes a polishing layer on at least one side. The term "polishing layer" used herein refers to a layer having a surface that comes in contact with a polishing target during CMP (hereinafter referred to as "polishing surface"). The chemical mechanical polishing pad may include an additional layer that does not have a polishing surface between the polishing layer and a support layer. Such an additional layer does not fall under the term "polishing layer". The polishing layer is formed by the following method using a composition that includes a thermoplastic polyurethane (hereinafter may be referred to as "thermoplastic polyurethane-containing composition"). The polishing layer has a specific gravity of 1.15 to 1.30 and a durometer D hardness of 50 to 80. The chemical mechanical polishing pad according to one embodiment of the invention is described in detail below.

1.1. Polishing layer

The polishing layer included in the chemical mechanical polishing pad according to one embodiment of the invention is formed by the following method using a thermoplastic polyurethane-containing composition (hereinafter may be referred to as "composition").

A polyurethane-containing polishing layer is normally classified into a foamed polishing layer and a non-foamed polishing layer. Since the non-foamed polishing layer has a specific gravity and a hardness higher than those of the foamed polishing layer, the non-foamed polishing layer is elastically deformed to a small extent when coming in contact with elevations and depressions of the polishing target surface (e.g., the surface of a wafer). Therefore, the polishing target surface is sufficiently planarized. However, since the hardness of the non-foamed polishing layer is higher than that of the foamed polishing layer, polishing defects (e.g., scratches) may increase due to polishing waste or pad waste present between the polishing target surface and the polishing layer.

On the other hand, the foamed polishing layer normally has low specific gravity and hardness. Therefore, polishing waste or pad waste that has entered the space between the polishing target surface (e.g., the surface of a wafer) and the polishing layer does not come in contact with the polishing target surface at high pressure since the surface of the foamed polishing layer is soft. Polishing defects can thus be suppressed. However, since the foamed polishing layer is elastically deformed to a large extent so as to follow elevations and depressions of the polishing target surface, the polishing target surface may not be sufficiently planarized. Accordingly, it has been considered that it is difficult to improve the planarity of the polishing target surface (e.g., the surface of a wafer) while suppressing occurrence of polishing defects (e.g., scratches).

The inventors of the invention found that it is possible to improve the planarity of the polishing target surface (e.g., the surface of a wafer) while suppressing occurrence of polishing defects (e.g., scratches) by forming a polishing layer using a thermoplastic polyurethane-containing composition while controlling the specific gravity and the hardness of the polishing layer.

1.1.1. Composition

1.1.1.1. Thermoplastic polyurethane

A polishing layer that exhibits excellent flexibility can be formed using a thermoplastic polyurethane-containing composition. In this case, since polishing waste or pad waste that has entered the space between the polishing target surface and the polishing layer does not come in contact with the polishing target surface at a high pressure, occurrence of polishing defects can be suppressed. Since a polishing layer formed using a polyurethane obtained by crosslinking a thermally crosslinkable polyurethane (thermosetting polyurethane) does not exhibit sufficient flexibility, it is difficult to suppress occurrence of polishing defects.

A polishing layer formed using a polyurethane which is obtained by crosslinking a thermally crosslinkable polyurethane and in which the molecular chains are firmly bonded, rarely swells even when coming in contact with water as compared with a polishing layer formed using a thermoplastic polyurethane, and has high surface hardness in the wet state. Therefore, when the polishing layer contains a crosslinked polyurethane, polishing waste or pad waste that has entered the space between the polishing target surface and the polishing layer comes in contact with the polishing target surface at a high pressure due to the surface of the polishing layer having high surface hardness, so that occurrence of polishing defects may not be suppressed.

The thermoplastic polyurethane included in the composition preferably includes a repeating unit derived from at least one compound selected from an alicyclic isocyanate and an aromatic isocyanate. When forming a polishing layer using a composition that includes a thermoplastic polyurethane having such a chemical structure, since it is possible to easily control the crystallinity of the polyurethane, the specific gravity, the hardness, and the like of the polishing layer can be easily controlled.

Examples of the alicyclic isocyanate include isophorone diisocyanate (IPDI), norbornene diisocyanate, hydrogenated 4,4'-diphenylmethane diisocyanate (hydrogenated MDI), and the like. These alicyclic isocyanates may be used either alone or in combination.

Examples of the aromatic isocyanate include aromatic diisocyanates such as 2,4-tolylene diisocyanate, 2,6-tolylene diisocyanate, 2,2'-diphenylmethane diisocyanate, 2,4'-diphenylmethane diisocyanate, 4,4'-diphenylmethane diisocyanate, naphthalene diisocyanate, 1,5-naphthalene diisocyanate, p-phenylene diisocyanate, m-phenylene diisocyanate, and p-xylene diisocyanate. Among these, 2,4-tolylene diisocyanate, 2,6-tolylene diisocyanate, and 4,4'-diphenylmethane diisocyanate are preferable since a reaction with a hydroxyl group can be easily controlled. These aromatic isocyanates may be used either alone or in combination.

The thermoplastic polyurethane included in the composition may include a repeating unit derived from the alicyclic isocyanate and a repeating unit derived from the aromatic isocyanate, or may further include a repeating unit derived from an additional isocyanate other than the alicyclic isocyanate and the aromatic isocyanate. Examples of the additional isocyanate include aliphatic diisocyanates such as ethylene diisocyanate, 2,2,4-trimethylhexamethylene diisocyanate, and 1,6-hexamethylene diisocyanate.

It is preferable that the thermoplastic polyurethane included in the composition include a repeating unit derived from the alicyclic isocyanate. When the thermoplastic polyurethane includes a repeating unit derived from the alicyclic isocyanate, the thermoplastic polyurethane exhibits appropriate hardness. Moreover, it is possible to more appropriately control the surface hardness of the resulting polishing layer in the wet state, and provide the resulting polishing layer with higher flexibility.

The thermoplastic polyurethane included in the composition preferably further includes a repeating unit derived from at least one compound selected from a polyether polyol, a polyester polyol, a polycarbonate polyol, and a polyolefin polyol. When the thermoplastic polyurethane includes a repeating unit derived from at least one compound selected from these polyols, the thermoplastic polyurethane exhibits improved water resistance.

The thermoplastic polyurethane included in the composition may include a repeating unit derived from a chain extender. Examples of the chain extender include low-molecular-weight dihydric alcohols such as ethylene glycol, propylene glycol, 1,3-propanediol, 1,3-butylene glycol, 1,4-butanediol, 1,5-pentanediol, 1,6-hexanediol, neopentyl glycol, 1,4-cyclohexanedimethanol, 3-methyl-1,5-pentanediol, diethylene glycol, triethylene glycol, and 1,4-bis(2-hydroxyethoxy)benzene. Among these, ethylene glycol, propylene glycol, 1,3-propanediol, 1,3-butylene glycol, 1,4-butanediol, 1,5-pentanediol, and 1,6-hexanediol are preferable, and 1,4-butanediol is more preferable, since a reaction with an isocyanate group can be easily controlled.

The thermoplastic polyurethane included in the composition preferably includes a repeating unit derived from at least one compound selected from the alicyclic isocyanate and the aromatic isocyanate in an amount of 2 to 60 parts by mass, and more preferably 3 to 55 parts by mass, based on 100 parts by mass of the thermoplastic polyurethane. When the thermoplastic polyurethane includes a repeating unit derived from at least one compound selected from the alicyclic isocyanate and the aromatic isocyanate in an amount within the above range, the thermoplastic polyurethane exhibits appropriate hardness. Moreover, it is possible to appropriately control the surface hardness of the resulting polishing layer in the wet state, and provide the resulting polishing layer with higher flexibility.

The thermoplastic polyurethane included in the composition may be produced by a normal polyurethane production method (e.g., batch method or prepolymer method).

1.1.1.2. Water-absorbing polymer compound

The composition may further include an additional polymer compound other than the thermoplastic polyurethane. The additional polymer compound that may be included in the composition is preferably a polymer compound that has a water absorption of 3 to 3000% (hereinafter may be referred to as "water-absorbing polymer compound"). When the composition includes the water-absorbing polymer compound, the polishing layer exhibits moderate water-absorbing properties, and it is possible to easily control volume change of the polishing layer that may occur when the polishing layer swells due to absorption of water.

The water-absorbing polymer compound more preferably includes at least one type of bond selected from an ether bond, an ester bond, and an amide bond.

Examples of the water-absorbing polymer compound that includes an ether bond include polyoxyethylene, a polyoxyethylene alkyl ether, a polyoxyethylene alkylphenol ether, a poly(ether ester amide), a poly(ether amide imide), polypropylene glycol, polyoxypropylene butyl ether, polyoxypropylene glyceryl ether, polyoxypropylene sorbitol, an oxyethylene/epichlorohydrin copolymer, a methoxypolyethylene glycol (meth)acrylate copolymer, polyoxyethylene lauryl ether, polyoxyethylene cetyl ether, polyoxyethylene oleyl ether, polyoxyethylene oleyl cetyl ether, polyoxyethylene polyoxypropylene glycol, polyoxyethylene polyoxypropylene butyl ether, polyoxyethylene polyoxypropylene hexylene glycol ether, polyoxyethylene polyoxypropylene trimethylolpropane, polyoxyethylene polyoxypropylene glyceryl ether, a copolymer of an olefin and a monomer that includes an ether bond, a chlorine-containing polyether, a polyacetal resin, an alkyl glucoside, a polyoxyethylene fatty acid amine, and the like.

Examples of the water-absorbing polymer compound that includes an ester bond include a polyoxyethylene fatty acid ester, a sucrose fatty acid ester, a sorbitan fatty acid ester, a polyoxyethylene sorbitan fatty acid ester, a glycerol fatty acid ester, an acrylate copolymer (acrylic rubber), and the like. Examples of the polyoxyethylene fatty acid ester include polyethylene glycol monostearate, polyethylene glycol laurate, polyethylene glycol monooleate, polyethylene glycol distearate, and the like.

Examples of the water-absorbing polymer compound that includes an amide bond include a fatty acid alkanolamide, a modified polyamide resin, and the like.

The polystyrene-reduced weight average molecular weight of the water-absorbing polymer compound as determined by gel permeation chromatography is 500 to 1,000,000, and more preferably 5000 to 500,000.

The water absorption of the water-absorbing polymer compound may be determined in accordance with JIS K 6258, as described below. Specifically, the polymer compound is formed into a sheet (thickness: 2 mm). The sheet is cut to have a size of $2\times2$ cm, and immersed in water at 23°C for 24 hours. The mass (M1) of the sheet in air before being immersed in water and the mass (M3) of the sheet in air after being immersed in water are measured, and the mass change rate is calculated by the following expression (1), and taken as the water absorption.

$$\text{Water absorption (\%)} = ((M3-M1)/M1)\times100 \qquad (1)$$

The composition preferably includes the water-absorbing polymer compound in an amount of 1 to 20 parts by mass, more preferably 3 to 15 parts by mass, and particularly preferably 5 to 10 parts by mass, based on the total amount (=100 parts by mass) of the thermoplastic polyurethane and the water-absorbing polymer compound. When the composition includes the water-absorbing polymer compound in an amount within the above range, the volume change rate of the polishing layer in the wet state can be easily controlled within the range of 0.8 to 5.0%. When the volume change rate of the polishing layer is within the above range, the surface of the polishing layer is moderately softened when the polishing layer absorbs water. Therefore, the polishing target surface can be sufficiently planarized, and occurrence of polishing defects (scratches) can be suppressed.

1.1.1.3. Water-soluble particles

The composition may further include water-soluble particles. When the composition includes the water-soluble particles, it is preferable that the water-soluble particles be uniformly dispersed in the composition. A polishing layer in which water-soluble particles are uniformly dispersed can be formed using such a composition.

When the polishing layer that includes the water-soluble particles comes in contact with a polishing aqueous dispersion that contains abrasive grains and chemicals (hereinafter may be referred to as "slurry"), the water-soluble particles are removed from the surface of the polishing layer, so that pores that hold the slurry are formed. In this case, the slurry can be further sufficiently held by the polishing layer since pores are formed in the surface of the polishing layer without using a polyurethane foam having a cell structure. It is also possible to control the surface hardness of the polishing layer in the wet state due to the pores formed in the surface of the polishing layer. Moreover, the specific gravity of the polishing layer can be increased by utilizing particles having a high specific gravity as the water-soluble particles.

When the thermoplastic polyurethane-containing composition includes the water-soluble particles, the following advantages can be obtained: (1) since the water-soluble particles serve as a reinforcing agent (e.g., filler), elastic deformation of the polishing layer can be reduced, so that it is possible to improve the planarity of the polishing target surface; (2) since a non-foamed polishing layer is formed, the polishing layer exhibits excellent mechanical strength; and (3) since it is unnecessary to uniformly control a foamed cell structure, the productivity can be improved.

Examples of the water-soluble particles include, but are not limited to, organic water-soluble particles and inorganic water-soluble particles. Specific examples of the water-soluble particles include a substance that is dissolved in water (e.g., water-soluble polymer), and a substance that swells or gels when coming in contact with water and is removed from the surface of the polishing layer (e.g., water-absorbing resin).

Examples of a material for forming the organic water-soluble particles include a saccharide (e.g., polysaccharide (e.g., starch, dextrin, and cyclodextrin), lactose, and mannitol), a cellulose (e.g., hydroxypropyl cellulose and methyl cellulose), a protein, a polyvinyl alcohol, polyvinylpyrrolidone, polyacrylic acid, polyethylene oxide, sulfonated polyisoprene, a sulfonated isoprene copolymer, and the like.

Examples of a material for forming the inorganic water-soluble particles include potassium acetate, potassium nitrate, potassium carbonate, potassium hydrogen carbonate, potassium bromide, potassium phosphate, potassium sulfate, magnesium sulfate, calcium nitrate, and the like.

The water-soluble particles may be formed using one or more materials among the materials for forming the organic water-soluble particles or the inorganic water-soluble particles. The water-soluble particles are preferably solid since the polishing layer exhibits appropriate mechanical strength (e.g., hardness).

The composition preferably includes the water-soluble particles in an amount of 3 to 150 parts by mass based on 100 parts by mass of the thermoplastic polyurethane. When the composition includes the water-soluble particles in an amount within the above range, it is possible to form a polishing layer that achieves a high chemical mechanical polishing removal rate, and exhibits appropriate mechanical strength (e.g., hardness).

It is preferable that the water-soluble particles have an average particle size of 0.5 to 200 micrometers. The size of pores formed when the water-soluble particles are removed from the surface of the polishing layer included in the chemical mechanical polishing pad is preferably 0.1 to 500 micrometers, and more preferably 0.5 to 200 micrometers. When the average particle size of the water-soluble particles is within the above range, it is possible to obtain a chemical mechanical polishing pad that includes a polishing layer that achieves a high polishing removal rate and exhibits excellent mechanical strength.

### 1.1.2. Specific gravity

The specific gravity of the polishing layer included in the chemical mechanical polishing pad according to one embodiment of the invention is 1.15 to 1.30, and preferably 1.18 to 1.27. When the specific gravity of the polishing layer is within the above range, the polishing target surface can be sufficiently planarized since the polishing layer exhibits appropriate hardness. It is also possible to suppress occurrence of polishing defects (scratches) since the polishing layer exhibits moderate elastic deformation (i.e., followability) along elevations and depressions of the polishing target surface. If the specific gravity of the polishing layer is less than 1.15, the hardness of the polishing layer may become too low, so that the polishing target surface may not be sufficiently planarized. If the specific gravity of the polishing layer is more than 1.30, the hardness of the polishing layer may become too high, so that the number of polishing defects (scratches) may increase.

The upper limit of the specific gravity of the polishing layer is 1.30, taking account of the balance between the specific gravity of a known polyurethane and the hardness of the polishing layer. It is necessary to use a material having a high specific gravity together with a urethane in order to produce a polishing layer having a specific gravity of more than 1.30. For example, a polishing layer having a specific gravity of more than 1.30 may be formed by mixing a urethane with a material having a high specific gravity (e.g., silica or alumina) as a filler. However, the resulting polishing layer has high hardness due to the filler, so that the number of scratches on the polishing target surface increases to a large extent. Therefore, it is impossible to achieve the effects of the invention.

The specific gravity of the polishing layer may be measured in accordance with JIS Z 8807, as described below. Specifically, a Le Chatelier specific gravity bottle containing water is charged with a sample having a known mass, and the volume of the sample is determined by measuring a change in water level. The specific gravity of the sample is calculated from the mass and the volume of the sample.

It is preferable that the polishing layer included in the chemical mechanical polishing pad according to one embodiment of the invention be a non-foamed polishing layer in order to obtain a specific gravity within the above range. The term "non-foamed polishing layer" used herein refers to a polishing layer that does not substantially include bubbles. For reference, the specific gravity of a commercially available urethane pad that includes a foamed polishing layer (e.g., "IC 1000" manufactured by Rohm & Haas) is about 0.40 to about 0.90.

### 1.1.3. Durometer D hardness

The durometer D hardness of the polishing layer included in the chemical mechanical polishing pad according to one embodiment of the invention is 50 to 80, preferably 55 to 80, more preferably 55 to 75, and particularly preferably 60 to 70.

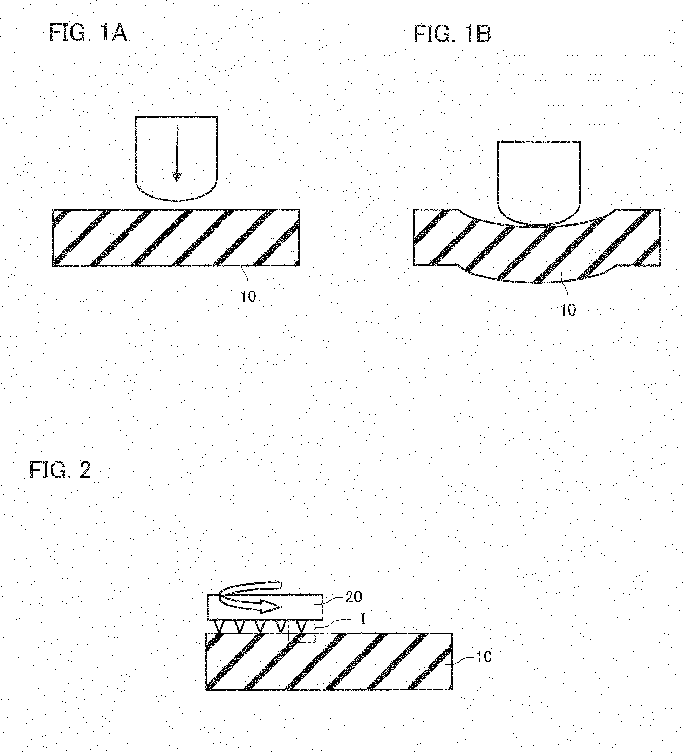

FIGS. 1A and 1B are schematic views illustrating the concept of the durometer D hardness of the polishing layer. When applying load to a polishing layer 10 from above (in the same manner as in a polishing step) as illustrated in FIG. 1A, the polishing layer 10 is warped as illustrated in FIG. 1B. The durometer D hardness is an index of the degree of macroscopic warping of the polishing layer 10 when applying load to the polishing layer 10 in the polishing step. This can be understood by the measurement method described below. When the durometer D hardness of the polishing layer is within the above range, the polishing target surface can be sufficiently planarized since the polishing layer has moderate durometer D hardness. It is also possible to suppress occurrence of polishing defects (scratches) since the polishing layer exhibits moderate elastic deformation (i.e., followability) along elevations and depressions of the polishing target surface. If the durometer D hardness of the polishing layer is less than 50, the polishing target may not be sufficiently planarized. If the durometer D hardness of the polishing layer is more than 80, the number of polishing defects (scratches) may increase.

The durometer D hardness of the polishing layer may be measured in accordance with JIS K 6253, as described below. Specifically, a specimen is placed on a flat and rigid surface. A type D durometer is held so that the pressure plate of the type D durometer is parallel to the surface of the specimen, and the indenter is perpendicular to the surface of the specimen. The pressure plate is then caused to come in contact with the specimen without applying an impact to the specimen. Note that the measurement point (at which the end of the indenter comes in contact with the specimen) is apart from the edge of the specimen by 12 mm or more. When 15 seconds has elapsed after causing the pressure plate to come in contact with the specimen, the hardness of the specimen is measured. The hardness of the specimen is measured five times at measurement points that are apart from each other by 6 mm or more. The average value of the measured values is taken as the durometer D hardness.

1.1.4. Residual strain when applying tension

The residual strain of the polishing layer included in the chemical mechanical polishing pad according to one embodiment of the invention when applying tension to the polishing layer is preferably 2 to 10%, and more preferably 2 to 9%.

A polishing layer normally has minute pores and/or depressions in its surface. Polishing waste or pad waste is gradually accumulated in the pores and/or the depressions (i.e., clogging occurs), so that the polishing properties of the polishing pad deteriorate. In this case, the surface of the polishing layer is ground by dressing using a diamond grinding wheel (hereinafter may be referred to as "diamond conditioning") so as to obtain a surface in the initial state. The surface of the polishing layer may be roughened, or pad waste may occur during diamond conditioning.

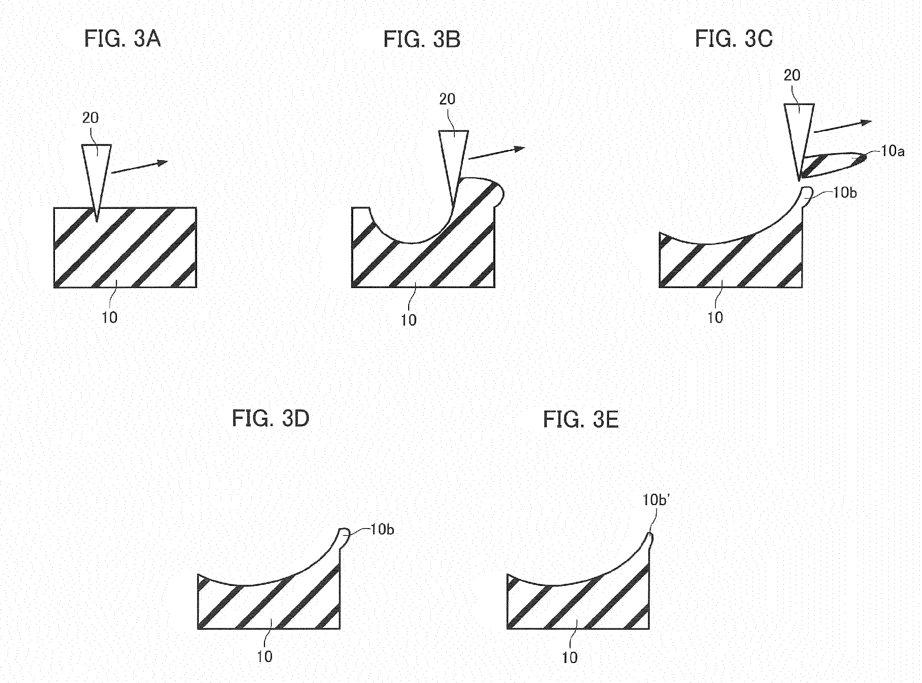

FIG. 2 is a schematic view illustrating the concept of the residual strain when applying tension to the polishing layer. FIGS. 3A to 3E are enlarged views of an area I in FIG. 2 that illustrate the concept of the residual strain when applying tension to the polishing layer. As illustrated in FIG. 2, the surface of the polishing layer 10 is ground during diamond conditioning using a dresser 20 that is rotated in the direction indicated by the arrow. When dressing the polishing layer 10, part of the surface of the polishing layer 10 is pulled by the dresser 20, as illustrated in FIGS. 3A and 3B. As illustrated in FIG. 3C, part of the surface of the polishing layer 10 is cut to produce pad waste. As illustrated in FIG. 3D, an elongated portion 10b shrinks so as to return to the original state due to the elasticity of the polishing layer. In this case, a roughened portion 10b' (see FIG. 3E) is formed corresponding to the residual strain of the polishing layer. Therefore, the residual strain of the polishing layer when applying tension to the polishing layer is an index that indicates the degree of roughness of the surface of the polishing layer during diamond conditioning.

When the residual strain of the polishing layer when applying tension to the polishing layer is within the above range, occurrence of pad waste and roughening of the surface of the polishing layer due to diamond conditioning can be suppressed. It is also possible to suppress deformation of the polishing layer due to elevations and depressions of the polishing target surface (e.g., the surface of a wafer). This makes it possible to improve the planarity of the polishing target surface while suppressing occurrence of polishing defects. If the residual strain of the polishing layer when applying tension to the polishing layer is less than 2%, the amount of pad waste that occurs when subjecting the surface of the polishing layer to diamond conditioning may increase, so that the number of polishing defects may increase due to the pad waste in the polishing step. If the residual strain of the polishing layer when applying tension to the polishing layer is more than 10%, the surface of the polishing layer may be roughened to a large extent when subjecting the surface of the polishing layer to diamond conditioning, and the polishing layer may exhibit large deformation along elevations and depressions of the polishing target surface. As a result, the polishing target surface may not be sufficiently planarized.

The residual strain of the polishing layer when applying tension to the polishing layer may be measured in accordance with JIS K 6270, as described below. A residual strain tester includes a plurality of fixed clamps that hold one end of a specimen, a plurality of reciprocating clamps that hold the other end of the specimen, a driver device that reciprocates the reciprocating clamps at a given frequency and a given amplitude, a counter that displays the number of reciprocations of the reciprocating clamps, and the like. Two specimens in the shape of a dumbbell are held by the clamps. After reciprocating the reciprocating clamps $1 \times 10$ times, the operation of the tester is stopped so that no stress is applied to one of the specimens. When 1 minute has elapsed, the bench mark distance of the specimen is measured. After reciprocating the reciprocating clamps 100 times, the bench mark distance of the other specimen is measured in the same manner as described above. The test is normally performed at a frequency of 1 to 5 Hz. The residual strain (%) when applying tension to the specimen is calculated by the following expression (2) using the bench mark distance ($I_0$) measured before the test and the bench mark distance ($I_n$) measured after the test in a state in which tension is not applied to the specimen.

$$\text{Residual strain when applying tension (\%)} = ((I_n\text{-}I_0)/I_0)\times100 \qquad (2)$$

The temperature and the humidity during the measurement are set in accordance with "6.1 Standard temperature in test room" and "6.2 Standard humidity in test room" defined in JIS K 6250. Specifically, the standard temperature in the test room is 23°C (allowance: $\pm2$°C). The standard humidity (relative humidity) in the test room is 50% (allowance: $\pm10$%).

1.1.5. Volume change rate

The volume change rate of the polishing layer included in the chemical mechanical polishing pad according to one embodiment of the invention when immersing the polishing layer in water at 23°C for 24 hours is preferably 0.8 to 5%, and more preferably 1 to 3%.

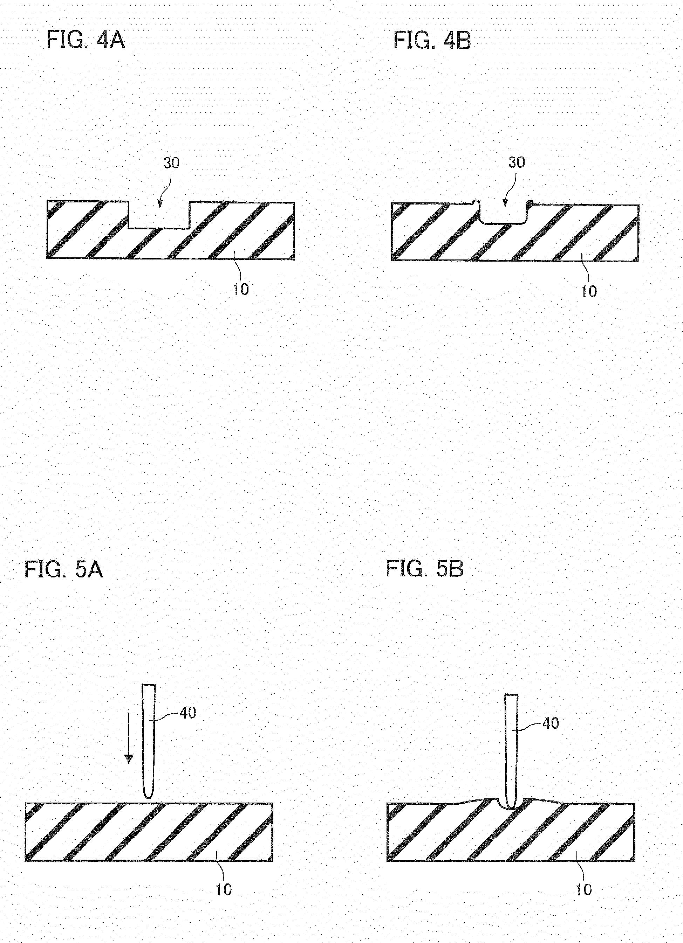

FIGS. 4A and 4B are schematic views illustrating the concept of the volume change rate of the polishing layer. The chemical mechanical polishing pad is always exposed to the slurry during polishing. As illustrated in FIG. 4A, a depression 30 is formed in the polishing layer 10 to have given dimensions and a given shape. As illustrated in FIG. 4B, the depression 30 may change in dimensions, shape, degree of roughening, or the like when the polishing layer 10 swells due to absorption of water. When the volume change rate of the polishing layer when immersing the polishing layer in water is within the above range, the surface of the polishing layer is moderately softened when the polishing layer swells due to absorption of water, so that occurrence of scratches can be suppressed. If the volume change rate of the polishing layer is less than 0.8%, the surface of the polishing layer may not be sufficiently softened since the polishing layer may swell to only a small extent due to absorption of water, so that occurrence of scratches may not be sufficiently suppressed. If the volume change rate of the polishing layer is more than 5%, the polishing layer may swell to a large extent due to absorption of water, so that the polishing target surface may not be sufficiently planarized although occurrence of scratches may be suppressed. When a depression pattern is formed in the polishing surface of the polishing layer, the dimensions or the shape of the depression pattern may change depending on the polishing time if the polishing layer swells to a large extent due to absorption of water. As a result, stable polishing properties may not be achieved. Therefore, it is preferable to prevent a situation in which the polishing layer swells to a large extent in order to prevent deformation of the polishing surface.

The volume change rate of the polishing layer is determined in accordance with JIS K 6258, as described below. Specifically, a polishing layer having a thickness of 2.8 mm is cut to have a size of 2×2 cm, and immersed in water at 23°C for 24 hours. The mass (M1) of the specimen in air before being immersed in water, the mass (M2) of the specimen in water before being immersed in water, the mass (M3) of the specimen in air after being immersed in water, and the mass (M4) of the specimen in water after being immersed in water are measured, and the volume change rate is calculated by the following expression (3).

$$\text{Volume change rate (\%)} = (((M3\text{-}M4)\text{-}(M1\text{-}M2))/(M1\text{-}M2))\times100 \qquad (3)$$

1.1.6. Surface hardness of polishing layer in wet state

The surface hardness of the polishing layer included in the chemical mechanical polishing pad according to one embodiment of the invention in the wet state is preferably 2 to 10 N/mm$^2$, more preferably 3 to 9 N/mm$^2$, and particularly preferably 4 to 8 N/mm$^2$. The surface hardness of the polishing layer in the wet state is an index that indicates the surface hardness of the polishing layer during CMP. FIGS. 5A and 5B are schematic views illustrating the concept of the surface hardness of the polishing layer. As illustrated in FIG. 5A, a minute probe 40 is pressed against the surface of the polishing layer 10. An area of the polishing layer 10 directly below the probe 40 is deformed as illustrated in FIG. 5B due to the probe 40. The surface hardness thus indicates the degree of deformation or warping of the uppermost surface of the polishing layer. Specifically, while data that indicates the macroscopic hardness of the entire polishing layer is obtained by measuring the durometer D hardness (i.e., hardness on millimeter scale) (see FIGS. 1A and 1B), data that indicates the microscopic hardness of the uppermost surface of the polishing layer is obtained by measuring the surface hardness of the polishing layer in the wet state (see FIGS. 5A and 5B). The polishing layer is depressed to a depth of 5 to 50 micrometers during CMP. Therefore, it is preferable to determine the flexibility of the uppermost surface of the polishing layer during CMP based on the surface hardness of the polishing layer in the wet state. When the surface hardness of the polishing layer in the wet state is within the above range, the uppermost surface of the polishing layer exhibits moderate flexibility, so that occurrence of polishing defects (scratches) can be suppressed. If the surface hardness of the polishing layer in the wet state is less than 2 N/mm$^2$, the polishing target surface may not be sufficiently planarized. If the surface hardness of the polishing layer in the wet state exceeds 10 N/mm$^2$, the number of polishing defects (scratches) may increase. Note that the surface hardness of the polishing layer in the wet state is indicated by the universal hardness (HU) measured when pressing a nanoindenter ("HM2000" manufactured by FISCHER) against the polishing layer (that has been immersed in water at 23°C for 4 hours) at 300 mN.

1.1.7. Shape of polishing layer and depressions

The planar shape of the polishing layer is not particularly limited, but may be circular. When the polishing layer has a circular planar shape, the diameter of the polishing layer is preferably 150 to 1200 mm, and more preferably 500 to 1000 mm. The thickness of the polishing layer is preferably 0.5 to 5.0 mm, more preferably 1.0 to 4.0 mm, and particularly preferably 1.5 to 3.5 mm.

A plurality of depressions may be formed in the polishing surface of the polishing layer. The depressions serve as a path that holds the slurry supplied during CMP, uniformly distributes the slurry over the polishing surface, temporarily stores waste (e.g., polishing waste, pad waste, or spent slurry), and discharges the waste to the outside.

The depth of the depressions is preferably 0.1 mm or more, more preferably 0.1 to 2.5 mm, and particularly preferably 0.2 to 2.0 mm. The width of the depressions is preferably 0.1 mm or more, more preferably 0.1 to 5.0 mm, and particularly preferably 0.2 to 3.0 mm. The interval between the depressions adjacent to each other is preferably 0.05 mm or more, more preferably 0.05 to 100 mm, and particularly preferably 0.1 to 10 mm. The pitch (i.e., the sum of the width of the depression and the distance between the depressions adjacent to each other) is preferably 0.15 mm or more, more preferably 0.15 to 105 mm, and particularly preferably 0.6 to 13 mm. The depressions may be formed at constant intervals within the above range. It is possible to easily obtain a chemical mechanical polishing pad that achieves an excellent effect of suppressing occurrence of scratches in the polishing target surface and has a long lifetime by forming the depressions as described above.

Each preferable range may be arbitrarily combined. For example, it is preferable that the depressions have a depth of 0.1 mm or more, a width of 0.1 mm or more, and an interval of 0.05 mm or more. It is more preferable that the depressions have a depth of 0.1 to 2.5 mm, a width of 0.1 to 5.0 mm, and an interval of 0.05 to 100 mm. It is particularly preferable that the depressions have a depth of 0.2 to 2.0 mm, a width of 0.2 to 3.0 mm, and an interval of 0.1 to 10 mm.

The depressions may be formed using a multi-blade tool having the shape disclosed in JP-A-2006-167811, JP-A-2001-18164, JP-A-2008-183657, or the like. The cutting blades of the tool may include a coating layer formed using diamond, or at least one metal element selected from the group 4, 5, and 6 metals (e.g., Ti, Cr, Zr, and V) and at least one non-metal element selected from nitrogen, carbon, and oxygen. The cutting blades may include a plurality of coating layers that differ in material. The thickness of the coating layer is preferably 0.1 to 5 micrometers, and more preferably 1.5 to 4 micrometers. The coating layer may be formed by an appropriate known technique (e.g., technique using an arc ion plating apparatus) depending on the material for the tool, the material for the coating layer, and the like.

1.1.8. Production method

The polishing layer included in the chemical mechanical polishing pad according to one embodiment of the invention may be obtained by molding the thermoplastic polyurethane-containing composition. The composition may be mixed using a known mixer or the like. Examples of the mixer include a roller, a kneader, a Banbury mixer, an extruder (single-screw extruder or multi-screw extruder), and the like. For example, the composition that has been plasticized at 120 to 230°C may be molded by press molding, extrusion molding, or injection molding, and plasticized/sheeted to obtain a polishing layer. The specific gravity and the hardness of the polishing layer may be controlled by appropriately adjusting the molding conditions.

Depressions may be formed in the polishing surface of the polishing layer by cutting. It is also possible to form the depressions and the polishing layer at the same time by molding the composition using a mold provided with a depression pattern.

1.2. Support layer

The chemical mechanical polishing pad according to one embodiment of the invention may include only the polishing layer, or may further include a support layer that is provided on the surface of the polishing layer opposite to the polishing surface.

The support layer included in the chemical mechanical polishing pad is used to support the polishing layer on a platen of a polishing system. The support layer may be an adhesive layer, or a cushion layer that has an adhesive layer on each side.

The adhesive layer may be a pressure-sensitive adhesive sheet, for example. The thickness of the pressure-sensitive adhesive sheet is preferably 50 to 250 micrometers. When the pressure-sensitive adhesive sheet has a thickness of 50 micrometers or more, it is possible to sufficiently reduce the pressure applied to the polishing surface of the polishing layer. When the pressure-sensitive adhesive sheet has a thickness of 250 micrometers or less, it is possible to obtain a chemical mechanical polishing pad having such a uniform thickness that the polishing performance is not affected by elevations or depressions of the polishing target surface.

A material for forming the pressure-sensitive adhesive sheet is not particularly limited insofar as the polishing layer can be secured on the platen of the polishing system. The material for forming the pressure-sensitive adhesive sheet is preferably an acrylic material or a rubber material that has a modulus of elasticity lower than that of the polishing layer.

The adhesive strength of the pressure-sensitive adhesive sheet is not particularly limited insofar as the chemical mechanical polishing pad can be secured on the platen of the polishing system. The adhesive strength of the pressure-sensitive adhesive sheet is preferably 3 N/25 mm or more, more preferably 4 N/25 mm or more, and particularly preferably 10 N/25 mm or more, as measured in accordance with JIS Z 0237.

The material for forming the cushion layer is not particularly limited insofar as the material has a hardness lower than that of the polishing layer. The cushion layer may be formed of a porous body (foam) or a non-porous body. Examples of the cushion layer include a layer obtained by molding a polyurethane foam or the like. The thickness of the cushion layer is preferably 0.1 to 5.0 mm, and more preferably 0.5 to 2.0 mm.

2. Chemical mechanical polishing method

A chemical mechanical polishing method according to one embodiment of the invention includes chemically and mechanically polishing a polishing target using the chemical mechanical polishing pad according to one embodiment of the invention. The chemical mechanical polishing pad includes the polishing layer that is formed using the thermoplastic polyurethane-containing composition and has a specific gravity and a hardness within the specific range. Therefore, the chemical mechanical polishing method according to one embodiment of the invention can improve the planarity of the polishing target surface and suppress occurrence of polishing defects (scratches) during CMP.

The chemical mechanical polishing method according to one embodiment of the invention may be implemented using a commercially available chemical mechanical polishing system. Examples of the commercially available chemical mechanical polishing system include EPO-112 and EPO-222 (all manufactured by Ebara Corporation); LGP-510 and LGP-552 (all manufactured by Lapmaster SFT); Mirra and Reflexion LK (all manufactured by Applied Materials); and the like.

A suitable slurry may be appropriately selected depending on the polishing target (e.g., copper film, insulating film, or low-dielectric-constant insulating film).

3. Examples

The invention is further described below by way of examples. Note that the invention is not limited to the following examples.

3.1. Production of chemical mechanical polishing pad

3.1.1. Example 1

50 parts by mass of a non-alicyclic thermoplastic polyurethane ("Elastollan 1174D" manufactured by BASF, hardness: 70), 50 parts by mass of an alicyclic thermoplastic polyurethane ("Elastollan NY 1197A" manufactured by BASF, hardness: 61), and 29 parts by mass of beta-cyclodextrin ("Dexy Pearl beta-100" manufactured by Ensuiko Sugar Refining Co., Ltd., average particle size: 20 micrometers) (water-soluble particles) were mixed using an extruder heated to 200°C to prepare a thermoplastic polyurethane composition. The thermoplastic polyurethane composition was compression-molded at 180°C in a press mold to obtain a cylindrical molded product (diameter: 845 mm, thickness: 3.2 mm). The surface of the molded product was ground using sandpaper to adjust the thickness. A plurality of concentric depressions (width: 0.5 mm, depth: 1.0 mm, pitch: 1.5 mm) were formed in the surface of the molded product using a cutting machine (manufactured by Kato Machine Corporate), and the periphery of the molded product was cut to obtain a polishing layer (diameter: 600 mm, thickness: 2.8 mm). The surface of the polishing layer in which the depressions were not formed was laminated with a double-sided tape "#422JA" (manufactured by 3M) to produce a chemical mechanical polishing pad.

3.1.2. Examples 2 to 7 and Comparative Examples 1 to 3

Chemical mechanical polishing pads of Examples 2 to 7 and Comparative Examples 1 to 3 were produced in the same manner as in Example 1, except for changing the type and the amount of each component of the composition as shown in Table 1 or 3.

3.1.3. Examples 8 and 9

A four-necked separable flask (2 1) equipped with a stirrer was charged with 38 parts by mass of polyoxyethylene bisphenol A ether ("Uniol DA400" manufactured by NOF Corporation) and 31 parts by mass of polytetramethylene glycol ("PTG-1000SN" manufactured by Hodogaya Chemical Co., Ltd., Mn=1012) in air. The mixture was stirred at 40°C. After the addition of 31 parts by mass of 4,4'-diphenylmethane diisocyanate ("MILLIONATE MT" manufactured by Nippon Polyurethane Industry Co., Ltd., dissolved in an oil bath at 80°C), the mixture was stirred for 15 minutes. The mixture was spread over a surface-treated SS vat, allowed to stand (reacted) at 110°C for 1 hour, and annealed at 80°C for 16 hours to obtain a thermoplastic polyurethane A. A chemical mechanical polishing pad was produced in the same manner as in Example 1, except for using the polyurethane A as the thermoplastic polyurethane, and changing the type and the amount of each component of the composition as shown in Table 1. 3.1.4. Example 10

67 parts by mass of a thermoplastic polyurethane ("Elastollan 1174D" manufactured by BASF), 30 parts by mass of a thermoplastic polyurethane ("Elastollan NY 1197A" manufactured by BASF), 3 parts by mass of a polyolefin/polyether copolymer ("PELESTAT 300" manufactured by Sanyo Chemical Industries Ltd., a water-absorbing polymer compound having a water absorption of 38%), and 20 parts by mass of beta-cyclodextrin ("Dexy Pearl beta-100" manufactured by Ensuiko Sugar Refining Co., Ltd, average particle size: 20 micrometers) (water-soluble particles) were mixed using an extruder heated to 180°C to prepare a thermoplastic polyurethane composition. A chemical mechanical polishing pad of Example 10 was produced in the same manner as in Example 1, except for using the thermoplastic polyurethane composition thus prepared.

3.1.5. Examples 11 to 14

Chemical mechanical polishing pads of Examples 11 to 14 were produced in the same manner as in Example 1, except for changing the type and the amount of each component of the composition as shown in Table 2.

3.1.6. Comparative Example 4

A four-necked separable flask (2 1) equipped with a stirrer was charged with 25 parts by mass of hydroxy-terminated polybutadiene ("NISSO PB G-1000" manufactured by Nippon Soda Co., Ltd.) and 35.8 parts by mass of polytetramethylene glycol ("PTMG-1000SN" manufactured by Hodogaya Chemical Co., Ltd.) in air. The mixture was stirred at 40°C. After the addition of 30.5 parts by mass of 4,4'-diphenylmethane diisocyanate ("MILLIONATE MT" manufactured by Nippon Polyurethane Industry Co., Ltd., dissolved in an oil bath at 80°C), the mixture was stirred for 10 minutes. After the addition of 8.4 parts by mass of 3-methyl-1,5-pentanediol ("MPD" manufactured by Kuraray Ltd.), the mixture was stirred. The mixture was spread over a surface-treated SS vat, allowed to stand and react at 110°C for 1 hour, and annealed at 80°C for 16 hours to obtain a thermoplastic polyurethane B. A chemical mechanical polishing pad was produced in the same manner as in Example 1, except for using the polyurethane B as the thermoplastic polyurethane, and changing the type and the amount of each component of the composition as shown in Table 3.

3.1.7. Comparative Example 5

A commercially available chemical mechanical polishing pad ("IC 1000" manufactured by Rohm & Haas, including a polishing layer formed using a thermally crosslinkable polyurethane) was used. The properties of the polishing layer were evaluated by the methods described below. The polishing layer had a specific gravity of 0.81, a durometer D hardness of 63, and a surface hardness of 14.5 N/mm$^2$. 3.1.8. Comparative Example 6

100 parts by mass of 1,2-polybutadiene ("RB830" manufactured by JSR Corporation, hardness: 47) and 38 parts by mass of beta-cyclodextrin ("Dexy Pearl beta-100" manufactured by Ensuiko Sugar Refining Co., Ltd, average particle size: 20 micrometers) (water-soluble particles) were mixed to prepare a composition. 1 part by mass of an organic peroxide ("Percumyl D-40" manufactured by NOF Corporation) was added to 100 parts by mass of the composition to prepare a thermally crosslinked polybutadiene resin containing water-soluble particles. A chemical mechanical polishing pad was produced in the same manner as in Example 1, except for using the thermally crosslinked polybutadiene resin.

The abbreviation of each component shown in Tables 1 to 3 has the following meaning.

"PU1-1": non-alicyclic thermoplastic polyurethane ("Elastollan 1174D" manufactured by BASF, hardness: 70)
"PU1-2": non-alicyclic thermoplastic polyurethane ("Elastollan 1164D" manufactured by BASF, hardness: 64)
"PU1-3": non-alicyclic thermoplastic polyurethane ("Elastollan 1180A" manufactured by BASF, hardness: 41)
"PU2-1": alicyclic thermoplastic polyurethane ("Elastollan NY 1197A" manufactured by BASF, hardness: 61)
"PU2-2": alicyclic thermoplastic polyurethane ("Elastollan NY 1164D" manufactured by BASF, hardness: 64)
"beta-CD": beta-cyclodextrin ("Dexy Pearl beta-100" manufactured by Ensuiko Sugar Refining Co., Ltd, average particle size: 20 micrometers)
"Thermally crosslinked polybutadiene resin": 1,2-polybutadiene ("RB830" manufactured by JSR Corporation, hardness: 47)
"Organic peroxide": dicumyl peroxide ("Percumyl D-40" manufactured by NOF Corporation, crosslinking agent)
"PM1": polyolefin/polyether copolymer ("PELESTAT 300" manufactured by Sanyo Chemical Industries Ltd., water absorption: 38%)
"PM2": polyalkylene oxide ("AQUA CALK TWB" manufactured by Sumitomo Seika Chemicals Company Limited, water absorption: 2050%)

3.2. Measurement of properties of polishing layer

3.2.1. Specific gravity

The specific gravity of the polishing layer produced in the section "3.1. Production of chemical mechanical polishing pad" and the polishing layer of the pad "IC 1000" was measured. The specific gravity was measured in accordance with JIS Z 8807. The results are shown in Tables 1 to 3.

3.2.2. Durometer D hardness

The durometer D hardness of the polishing layer produced in the section "3.1. Production of chemical mechanical polishing pad" and the polishing layer of the pad "IC 1000" was measured. The durometer D hardness of the polishing layer was measured in accordance with JIS K 6253. The results are shown in Tables 1 to 3.

3.2.3. Residual strain when applying tension

A specimen was prepared from the polishing layer produced in the section "3.1. Production of chemical mechanical polishing pad" and the polishing layer of the pad "IC 1000" in an area in which the depressions were not formed, and the residual strain when applying tension was measured. The residual strain when applying tension was measured in accordance with JIS K 6270. The temperature and the humidity (relative humidity) during the measurement were respectively 23°C and 50%. The results are shown in Tables 1 to 3.

3.2.4. Volume change rate

The volume change rate of the polishing layer produced in the section "3.1. Production of chemical mechanical polishing pad" and the polishing layer of the pad "IC 1000" was measured. The volume change rate of the polishing layer was measured in accordance with JIS K 6258, as described below. Specifically, the polishing layer having a thickness of 2.8 mm was cut into a square measurement specimen ($2 \times 2$ cm). The measurement specimen was immersed in water at 23°C for 24 hours. The mass (M1) of the measurement specimen in air before being immersed in water, the mass (M2) of the measurement specimen in water before being immersed in water, the mass (M3) of the measurement specimen in air after being immersed in water, and the mass (M4) of the measurement specimen in water after being immersed in water were measured using an electronic balance ("JP-300" manufactured by Cho Balance Co., Ltd.), and the volume change rate was calculated by the following expression (3). The results are shown in Tables 1 to 3.

$$\text{Volume change rate (\%)} = (((M3\text{-}M4)\text{-}(M1\text{-}M2))/(M1\text{-}M2)) \times 100 \qquad (3)$$

3.2.5. Surface hardness of polishing layer in wet state

The surface hardness of the polishing layer produced in the section "3.1. Production of chemical mechanical polishing pad" and the polishing layer of the pad "IC 1000" in the wet state was measured. The universal hardness (HU) measured when pressing a nanoindenter ("HM2000" manufactured by FISCHER) against the polishing layer (that had been immersed in water at 23°C for 4 hours) at 300 mN was taken as the surface hardness of the polishing layer in the wet state. The results are shown in Tables 1 to 3.

3.3. Evaluation of chemical mechanical polishing

The chemical mechanical polishing pad produced in the section "3.1. Production of chemical mechanical polishing pad" was installed in a chemical mechanical polishing system ("EPO-112" manufactured by Ebara Corporation), and dressed for 30 minutes using a dresser ("#325-63R" manufactured by A.L.M.T. Corp.) at a table rotational speed of 20 rpm, a dressing rotational speed of 19 rpm, and a dressing load of 5.1 kgf. A polishing target was chemically mechanically polished using the dressed chemical mechanical polishing pad under the following conditions, and the polishing properties were evaluated as described below.

    Head rotational speed: 61 rpm
    Head load: 3 psi (20.6 kPa)
    Table rotational speed: 60 rpm
    Slurry supply rate: 300 cm$^3$/min
    Slurry: CMS8401/CMS8452 (manufactured by JSR Corporation)

3.3.1. Evaluation of planarity

A polishing target (test substrate) was prepared by forming a PETEOS film (thickness: 5000 angstroms) on a silicon substrate, forming a mask pattern ("SEMATECH 854"), and sequentially forming a tantalum nitride film (thickness: 250 angstroms), a copper seed film (thickness: 1000 angstroms), and a copper film (thickness: 10,000 angstroms) over the mask pattern.

The polishing target was chemically and mechanically polished for 1 minute under the conditions described in the section "3.3. Evaluation of chemical mechanical polishing". The thickness of the polishing target was measured before and after CMP using an electric conduction-type thickness measurement system ("OmniMap RS75" manufactured by KLA-Tencor). The polishing removal rate was calculated from the thickness of the polishing target before CMP, the thickness of the polishing target after CMP, and the polishing time. An end point detection time at which Cu had been completely removed (i.e., Cu clear) was calculated from the time from the start of polishing to the end point detected based on a change in table torque current. The patterned wafer (polishing target) was polished for a time 1.2 times the end point detection time, and the amount of dishing of a copper interconnect (width: 100 micrometers) was measured in an area wherein a pattern in which a copper interconnect area (width: 100 micrometers) and an insulating area (width: 100 micrometers) were alternately provided, was continuously formed to a length of 3.0 mm in the direction perpendicular to the longitudinal direction, using a precise step meter ("HRP-240" manufactured by KLA-Tencor Corporation). The planarity of the polishing target surface was evaluated based on the amount of dishing. The results are shown in Tables 1 to 3. The amount of dishing is preferably less than 300 angstroms, more preferably less than 250 angstroms, and particularly preferably less than 200 angstroms.

3.3.2. Evaluation of scratches (scratch resistance)

The number of scratches that occurred on the polishing target surface of the patterned wafer due to polishing was counted using a wafer defect inspection system ("KLA 2351" manufactured by KLA-Tencor Corporation). The results are shown in Tables 1 to 3. The number of scratches is preferably less than 40, more preferably less than 20, and particularly preferably less than 15.

TABLE 1

| | | | Example 1 | Example 2 | Example 3 | Example 4 | Example 5 | Example 6 | Example 7 | Example 8 | Example 9 |
|---|---|---|---|---|---|---|---|---|---|---|---|
| Composition | Thermoplastic polyurethane | PU1-1 (parts by mass) | 50 | 30 | 60 | 50 | - | - | - | - | - |
| | | PU1-2 (parts by mass) | - | - | - | - | 80 | - | 80 | - | - |
| | | PU1-3 (parts by mass) | - | - | - | - | - | 50 | - | - | - |
| | | PU2-1 (parts by mass) | 50 | 70 | 40 | 50 | - | 50 | - | - | - |
| | | PU2-2 (parts by mass) | - | - | - | - | 20 | - | 20 | - | - |
| | | Polyurethane A (parts by mass) | - | - | - | - | - | - | - | 100 | 100 |
| | Other component | beta-CD (parts by mass) | 29 | 29 | 78 | 78 | 29 | 78 | 78 | 29 | - |
| Properties of polishing layer | Specific gravity | | 1.18 | 1.15 | 1.28 | 1.25 | 1.22 | 1.17 | 1.24 | 1.18 | 1.16 |
| | Durometer D hardness | | 67 | 63 | 77 | 75 | 64 | 54 | 75 | 73 | 65 |
| | Residual strain when applying tension (%) | | 4.8 | 7.8 | 5.5 | 5.0 | 7.2 | 9.8 | 2.0 | 2.5 | 5.0 |
| | Volume change rate (%) | | 1.0 | 1.3 | 1.6 | 1.7 | 1.2 | 2.3 | 1.7 | 0.9 | 0.8 |
| | Surface hardness (N/mm$^2$) | | 4.3 | 1.9 | 10.2 | 8.9 | 6.5 | 5.8 | 7.8 | 4.2 | 4.4 |
| Chemical mechanical polishing evaluation results | Number of scratches | | 14 | 7 | 26 | 19 | 14 | 6 | 28 | 16 | 18 |
| | Amount of dishing (angstroms) | | 188 | 265 | 175 | 184 | 196 | 280 | 228 | 200 | 210 |

TABLE 2

| | | | Example 10 | Example 11 | Example 12 | Example 13 | Example 14 |
|---|---|---|---|---|---|---|---|
| Composition | Thermoplastic polyurethane | PU1-1 (parts by mass) | 67 | - | - | - | 85 |
| | | PU1-2 (parts by mass) | - | 70 | 62 | 69 | - |
| | | PU1-3 (parts by mass) | - | - | - | - | |
| | | PU2-1 (parts by mass) | 30 | - | - | - | - |
| | | PU2-2 (parts by mass) | - | 20 | 20 | 30 | 10 |
| | | Polyurethane A (parts by mass) | - | - | - | - | - |
| | Water-absorbing polymer compound | PM1 (parts by mass) | 3 | 10 | 18 | - | - |
| | | PM2 (parts by mass) | - | - | - | 1 | 5 |
| | Other component | beta-CD (parts by mass) | 20 | 20 | 20 | 5 | 40 |
| Properties of polishing layer | Specific gravity | | 1.21 | 1.20 | 1.19 | 1.21 | 1.26 |
| | Durometer D hardness | | 67 | 62 | 60 | 64 | 72 |
| | Residual strain when applying tension (%) | | 9.8 | 7.8 | 8.2 | 7.0 | 9.5 |
| | Volume change rate (%) | | 1.7 | 2.2 | 2.8 | 3.2 | 4.6 |
| | Surface hardness (N/mm$^2$) | | 6.8 | 5.8 | 4.2 | 4.7 | 7.2 |
| Chemical mechanical polishing evaluation results | Number of scratches | | 35 | 18 | 5 | 16 | 4 |
| | Amount of dishing (angstroms) | | 190 | 210 | 250 | 240 | 280 |

TABLE 3

| | | | Comparative Example 1 | Comparative Example 2 | Comparative Example 3 | Comparative Example 4 | Comparative Example 5 | Comparative Example 6 |
|---|---|---|---|---|---|---|---|---|
| Composition | Thermoplastic polyurethane | PU1-1 (parts by mass) | 50 | 100 | - | - | IC 1000 (commercially available pad) | - |
| | | PU1-2 (parts by mass) | - | - | - | - | | - |
| | | PU1-3 (parts by mass) | - | - | 100 | - | | - |
| | | PU2-1 (parts by mass) | 50 | - | - | - | | - |
| | | PU2-2 (parts by mass) | - | - | - | - | | - |
| | | Polyurethane B (parts by mass) | - | - | - | 100 | | - |
| | Other component | beta-CD (parts by mass) | - | 78 | 29 | 29 | | 38 |
| | | Thermally crosslinked polybutadiene resin (parts by mass) | - | - | - | - | | 100 |
| | | Organic peroxide (parts by mass) | - | - | - | - | | 1.38 |
| Properties of polishing layer | Specific gravity | | 1.13 | 1.19 | 1.10 | 1.18 | 0.81 | 1.03 |
| | Durometer D hardness | | 64 | 81 | 48 | 45 | 63 | 67 |
| | Residual strain when applying tension (%) | | 13.7 | 1.9 | 28.7 | 10.5 | 8.0 | 7.0 |
| | Volume change rate (%) | | 0.8 | 2.5 | 2.7 | 0.7 | 0.2 | 0.1 |
| | Surface hardness (N/mm$^2$) | | 4.0 | 14.1 | 3.2 | 2.1 | 14.5 | 8.9 |

EP 2 517 828 A1

(continued)

| | | Comparative Example 1 | Comparative Example 2 | Comparative Example 3 | Comparative Example 4 | Comparative Example 5 | Comparative Example 6 |
|---|---|---|---|---|---|---|---|
| Chemical mechanical polishing evaluation results | Number of scratches | 12 | 103 | 19 | 2 | 125 | 130 |
| | Amount of dishing (angstroms) | 380 | 295 | 540 | 540 | 310 | 350 |

3.4. Chemical mechanical polishing pad evaluation results

As shown in Tables 1 and 2, the chemical mechanical polishing pads of Examples 1 to 14 showed excellent results for the flatness and the scratch resistance.

As shown in Table 3, the chemical mechanical polishing pads of Comparative Examples 1 to 6 showed poor results for the flatness and/or the scratch resistance. The chemical mechanical polishing pad of Comparative Example 1 containing an alicyclic thermoplastic polyurethane showed poor results for the flatness since the specific gravity of the polishing layer was not within the range of 1.15 to 1.30. The chemical mechanical polishing pad of Comparative Example 2 containing a non-alicyclic thermoplastic polyurethane showed unacceptable results for the scratch resistance since the durometer D hardness of the polishing layer was not within the range of 50 to 80. The chemical mechanical polishing pad of Comparative Example 3 containing a non-alicyclic thermoplastic polyurethane showed significantly poor results for the flatness since the specific gravity of the polishing layer was not within the range of 1.15 to 1.30 and the durometer D hardness was not within the range of 50 to 80. The chemical mechanical polishing pad of Comparative Example 4 containing the thermoplastic polyurethane B showed significantly poor results for the flatness since the durometer D hardness of the polishing layer was not within the range of 50 to 80. The chemical mechanical polishing pad of Comparative Example 6 containing polybutadiene and water-soluble particles showed poor results for the flatness and the scratch resistance since the specific gravity of the polishing layer was not within the range of 1.15 to 1.30.

The chemical mechanical polishing pad containing a thermally crosslinked foamed polyurethane as produced in Comparative Example 5 showed poor results for the flatness and the scratch resistance.

As is clear from the above results obtained in the examples and the comparative examples, the chemical mechanical polishing pad according to the embodiments of invention achieved excellent flatness and scratch resistance as a result of specifying the balance between the specific gravity and the hardness of the polishing layer formed using a thermoplastic polyurethane.

The invention is not limited to the above embodiments. Various modifications and variations may be made. For example, the invention includes various other configurations substantially the same as the configurations described in connection with the above embodiments (e.g., a configuration having the same function, method, and results, or a configuration having the same objective and results). The invention also includes a configuration in which an unsubstantial section (part) described in connection with the above embodiments is replaced by another section (part). The invention also includes a configuration having the same effects as those of the configurations described in connection with the above embodiments, or a configuration capable of achieving the same obj ective as that of the configurations described in connection with the above embodiments. The invention further includes a configuration in which a known technique is added to the configurations described in connection with the above embodiments.

REFERENCE SIGNS LIST

10: polishing layer, 10a: pad waste, 10b: elongated portion, 10b': roughened portion, 20: dresser, 30: depression, 40: probe

**Claims**

1. A chemical mechanical polishing pad comprising a polishing layer formed using a composition that includes a thermoplastic polyurethane, the polishing layer having a specific gravity of 1.15 to 1.30 and a durometer D hardness of 50 to 80.

2. The chemical mechanical polishing pad according to claim 1, wherein the polishing layer has a residual strain of 2 to 10% when applying tension to the polishing layer.

3. The chemical mechanical polishing pad according to claim 1 or 2, wherein the polishing layer has a volume change rate of 0.8 to 5.0% when immersed in water at 23°C for 24 hours.

4. The chemical mechanical polishing pad according to any one of claims 1 to 3, wherein the polishing layer has a surface hardness of 2 to 10 $N/mm^2$ after being immersed in water at 23°C for 4 hours.

5. The chemical mechanical polishing pad according to any one of claims 1 to 4, wherein the thermoplastic polyurethane includes a repeating unit derived from at least one compound selected from an alicyclic isocyanate and an aromatic isocyanate.

6. The chemical mechanical polishing pad according to any one of claims 1 to 5, wherein the composition further includes water-soluble particles.

7. A chemical mechanical polishing method comprising chemically and mechanically polishing a polishing target using the chemical mechanical polishing pad according to any one of claims 1 to 6.

FIG. 1A

FIG. 1B

10

10

FIG. 2

20

I

10

FIG. 3A

FIG. 3B

FIG. 3C

FIG. 3D

FIG. 3E

EP 2 517 828 A1

FIG. 4A

30

10

FIG. 4B

30

10

FIG. 5A

40

10

FIG. 5B

40

10

## INTERNATIONAL SEARCH REPORT

| International application No. |
| --- |
| PCT/JP2010/072430 |

A. CLASSIFICATION OF SUBJECT MATTER
*B24B37/00*(2006.01)i, *C08G18/74*(2006.01)i, *H01L21/304*(2006.01)i

According to International Patent Classification (IPC) or to both national classification and IPC

B. FIELDS SEARCHED

Minimum documentation searched (classification system followed by classification symbols)
B24B37/00, C08G18/74, H01L21/304

Documentation searched other than minimum documentation to the extent that such documents are included in the fields searched
Jitsuyo Shinan Koho        1922-1996    Jitsuyo Shinan Toroku Koho    1996-2011
Kokai Jitsuyo Shinan Koho  1971-2011    Toroku Jitsuyo Shinan Koho    1994-2011

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y | JP 2005-532176 A  (Cabot Microelectronics Corp.), 27 October 2005 (27.10.2005), claim 44; paragraphs [0009] to [0017], [0030] & US 2003/0220061 A1    & WO 03/095518 A1 & CN 001671509 A        & TW 000590853 B & KR 10-2008-0037719 A | 1-7 |
| Y | JP 2009-24213 A  (Toyo Tire and Rubber Co., Ltd.), 22 October 2009 (22.10.2009), paragraphs [0024] to [0033] (Family: none) | 1-7 |

| ☒ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search 21 February, 2011 (21.02.11) | Date of mailing of the international search report 01 March, 2011 (01.03.11) |
| --- | --- |
| Name and mailing address of the ISA/ Japanese Patent Office | Authorized officer |
| Facsimile No. | Telephone No. |

Form PCT/ISA/210 (second sheet) (July 2009)

**INTERNATIONAL SEARCH REPORT**

| International application No. |
| --- |
| PCT/JP2010/072430 |

| C (Continuation). DOCUMENTS CONSIDERED TO BE RELEVANT | | |
| --- | --- | --- |
| Category* | Citation of document, with indication, where appropriate, of the relevant passages | Relevant to claim No. |
| Y<br>A | JP 2001-47355 A (JSR Corp.),<br>20 February 2001 (20.02.2001),<br>paragraphs [0005] to [0014]<br>(Family: none) | 2-4<br>1,5-7 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 8500622 T
- JP 2000017252 A
- JP 3956364 B
- JP 2007284625 A
- JP 2003332277 A
- JP 2006167811 A
- JP 2001018164 A
- JP 2008183657 A
- JP 300 A